# EUROPÄISCHE PATENTSCHRIFT

(11) **EP 0 950 261 B1**
(45) Veröffentlichungstag und Bekanntmachung des Hinweises auf die Patenterteilung: **14.07.2004**
(21) Anmeldenummer: 98948702.0
(22) Anmeldetag: 31.07.1998
(51) Int. Cl.: H01L 23/482

(54) **HALBLEITERKÖRPER MIT RÜCKSEITENMETALLISIERUNG**
SEMICONDUCTOR WITH METAL COATING ON ITS REAR SURFACE
SEMICONDUCTEUR AVEC METALLISATION DE LA FACE ARRIERE

(30) Priorität: 08.08.1997 DE 19734434
(43) Veröffentlichungstag der Anmeldung: 20.10.1999
(73) Patentinhaber: Infineon Technologies AG, 81669 München (DE)
(72) Erfinder: LASKA, Thomas, D-80796 München (DE); MOIK, Gernot, A-9520 Sattendorf (AT); STEFANER, Werner, A-7500 Villach (AT); MÄTZLER, Andreas, A-9551 Bodensdorf (AT); MATSCHITSCH, Martin, A-9181 Feistritz i.R. (AT); MASCHER, Herbert, A-9640 Kötschach (AT)
(74) Vertreter: Patentanwälte Westphal, Mussgnug & Partner
(86) Internationale Anmeldenummer: PCT/DE1998/002199
(87) Internationale Veröffentlichungsnummer: WO 1999/008322

(56) Entgegenhaltungen:
- EP-A- 0 720 231
- DE-C- 19 603 654
- DE-U- 9 212 486
- US-A- 4 875 088

## Beschreibung

Die Erfindung bezieht sich auf einen aus Silizium bestehenden Halbleiterkörper, der mit einer metallenen Trägerplatte über eine Folge von Metallschichten verlötbar ist, die vor dem Löten ausgehend vom Silizium in Richtung zur Trägerplatte eine Aluminiumschicht und eine Diffusionssperrschicht aufweist.

Solche Halbleiterkörper sind in Halbleiterbauelemente, insbesondere in Leistungshalbleiterbauelemente, eingebaut, die sich in großer Zahl am Markt befinden. Die Folge von Metallschichten enthält in der Regel eine Aluminiumschicht, die auf einem Silizium-Halbleiterkörper sitzt. Die Aluminiumschicht haftet gut auf Silizium und bildet insbesondere mit p-dotiertem Silizium einen einwandfreien ohmschen Kontakt. Auf der Aluminiumschicht sitzt nach dem Stand der Technik eine Diffusionssperrschicht, die zumeist aus Titan oder Chrom besteht und als Haftvermittler und Rückseitenbarriere zwischen einer auf der Diffusionssperrschicht sitzenden weiteren Metallschicht, in der Regel einer Nickelschicht, und der Aluminiumschicht dient.

Aufgrund der unterschiedlichen thermischen Ausdehnungskoeffizienten zwischen den einzelnen Metallschichten einerseits und dem Siliziumhalbleiterkorper andererseits werden starke mechanische Spannungen verursacht. Insbesondere bei dünnen Halbleiterkörpern, d. h. bei Halbleiterkorpern, die eine Dikke kleiner gleich 250 µm aufweisen, kommt es zu starken Waferverbiegungen, d. h. zu Waferverbiegungen größer 1000 µm.

Dadurch ist das "handling" der Wafer erschwert, es kommt zu vermehrten Kasetten-Positionierfehlern und es tritt vermehrt eine Bruchgefahr beim Bearbeiten der Wafer auf.

Bisher wurde versucht diesem Problem dadurch abzuhelfen, daß die Nickelschichtdicke möglichst minimiert wurde, so daß die Lötung noch ausreichende Haftfestigkeit zeigte. Trotz reduzierter Nickelschichtdicken, d. h. Schichtdicken von ungefähr 1 µm, treten aber dennoch im Fertigungsbetrieb weiterhin Scheibenverbiegungen von 700 bis 2000 µm auf, die zu den obengenannten Problemen führen.

Insbesondere im Hinblick auf den Wunsch nach immer dünneren Halbleiterkörpern, d. h. Halbleiterkörpern die eine Dicke von ungefähr 100 µm aufweisen, stellt es sich ein Bedürfnis nach einem Metallisierungsprozeß ein, der den obengenannten Problemen Abhilfe schafft. Solche Halbleiterkorper werden insbesondere bei Leistungsfeldeffekttransistoren und IGBT's in Vertikalbauweise benötigt.

Aufgabe der vorliegenden Erfindung ist es daher, einen Silizium-Halbleiterkörper derart zu metallisieren, daß die Scheibenverbiegungen deutlich reduziert werden, ohne dabei Einbußen in der Haftfestigkeit auf den Trägermaterialien zu erleiden.

Die DE 38 23 347 Al beschreibt ein Halbleiterbauelement für hohe Strombelastbarkeit mit einem Kontaktschichtenaufbau des Halbleiterkörpers. Die Metallisierung besteht dabei aus einer ersten Schicht aus Aluminium, einer zweiten Schicht aus Chrom oder Titan als Haftschicht und als Diffusionsbarriere für das Aluminium, einer lötfähigen dritten Schicht aus Nickel sowie einer abschließenden Schutzschicht aus Gold oder Paladium oder aber aus einer lötfähigen Schicht mit je einer Teilschicht aus Nickel und Kupfer, wobei Kupfer gleichzeitig äußerste Schicht ist oder auch noch mit Gold oder Paladium abgedeckt sein kann. Ein ähnlicher Stand der Technik wird in dem Dokument DE-C-19 603 654 offenbart.

In den IEEE TPANSACTIONS ON ELECTRON DEVICES, 1986, Vol. ED-33, No. 3, Pages 402-408 ist ein Silizium-Leistungstransistor mit einer stufenförmigen Elektrodenstruktur und einer Titannitriddiffusionsbarriere beschrieben. Die Titannitrid-Diffusionssperrschicht ist zwischen einem Elektrodenanschluß aus Gold und einem Siliziumsubstrat als Titan-Titannitrid-Titanschichtenfolge aufgetragen. Hierdurch wird eine hohe Zuverlässigkeit und Lebensdauer der Verbindung erzielt sowie eine Gold-Siliziumreaktion verhindert.

Diese Aufgabe wird dadurch gelöst, daß als Diffusionssperrschicht eine Titanschicht vorgesehen ist, in die eine Titannitridschicht eingebracht ist.

Überraschenderweise hat es sich gezeigt, daß durch den Einbau einer Titannitridschicht in die als Diffusionssperrschicht dienende Titanschicht ein Großteil der auftretenden Scheibenverbiegungen kompensiert werden konnte.

Typischerweise wird auf die so prozessierte Diffusionssperrschicht dann eine Nickelschicht aufgebracht, auf welche entweder unter Abscheidung einer Haftvermittlerschicht oder ohne Haftvermittlerschicht eine Oxidationsschutzschicht, vorzugsweise eine Silberschicht, aufgebracht ist.

In einer alternativen Ausführung der vorliegenden Erfindung wird auf die Titanschicht direkt eine Lotmaterialschicht, die vorzugsweise aus Zinn oder Blei oder Gallium besteht, abgeschieden. Durch diese Vorgehensweise kann der Halbleiterkörper direkt auf die Trägerplatte durch Erwärmen auf Temperaturen oberhalb von etwa 250°C unmittelbar mit dieser verlötet werden, ohne daß eine separate Lotmaterialschicht mit einer Nickelschicht verlötet werden muß. Das Zufügen von weiteren Lötmitteln und Flußmitteln kann dann entfallen.

Die dadurch erzeugten Lotschichten sind nahezu spannungsfrei, so daß es nur noch zu marginalen Substratverbiegungen kommt.

Der aus Silizium bestehende Halbleiterkörper gemäß der vorliegenden Erfindung wird typischerweise mit dem folgenden Verfahren hergestellt. Das erfindungsgemäße Verfahren umfaßt folgende Schritte:
a) Auf den Halbleiterkorper wird eine Aluminiumschicht abgeschieden;
b) auf die Aluminiumschicht wird eine Titanschicht abgeschieden;
c) auf die Titanschicht wird eine Titannitridschicht abgeschieden;
d) auf die Titannitridschicht wird wiederum eine Titanschicht abgeschieden.

Eine besonders gute Rückseitenmetallisierung wird erreicht, indem auf den Halbleiterkörper zuerst eine dunne Aluminiumschicht aufgebracht wird und der so prozessierte Halbleiterkörper dann vorzugsweise bei ca. 350°C getempert wird. Nach erfolgter Temperung wird auf die erste Aluminiumschicht eine weitere Aluminiumschicht abgeschieden.

Durch das Zweiteile des Aluminiumbeschichtungsprozesses und der "in-situ-Temperung" des aluminiumbeschichteten Halbleiterkörpers wird die Wirkung der eingebauten Titannitridschicht in die Titanschicht besonders stabilisiert. Es hat sich namlich gezeigt, daß durch das Verlagern des Temperschrittes vom Ende des Metallisierungsprozesses in den Aluminiumbeschichtungsprozeß die günstigen Eigenschaften der Titannitridschicht weitgehend erhält.

Würde der Temperschritt am Ende der Metallisierung ausgeführt werden, so würde die günstige Eigenschaft der Titannitridschicht negativ beeinflußt werden, d. h. im schlimmsten Fall würden ungefähr 50% der streßkompensierenden Eigenschaften der Titannitridschicht verlorengehen.

Eine Beeinträchtigung des gesamten Metallisierungsprozesses durch die Verlagerung des Temperschrittes vom Ende der Metallisierung zum Aluminiumbeschichtungsprozeß findet nicht statt, da der Temperschritt lediglich dazu dient, eine besonders gute Kontaktierung zwischen Aluminium und Silizium herzustellen.

Typischerweise werden sämtliche Metallschichten im erfindungsgemäßen Verfahren aufgedampft.

Nach dem Ausführen des Verfahrensschrittes d) kann je nach dem, welche Vorgehensweise gewunscht ist, auf die Titanschicht eine Nickelschicht abgeschieden werden mit anschließender Abscheidung einer Oxidationsschutzschicht. Zwischen die Abscheidung einer Oxidationsschutzschicht und der Nickelschicht kann optional die Abscheidung einer Haftvermittlerschicht erfolgen, die ebenfalls wiederum aus Titan bestehen kann.

In einer alternativen Ausführung wird jedoch direkt auf den Verfahrensschritt d) das Aufbringen einer Lotmaterialschicht aus Zinn, Blei oder Gallium erfolgen.

Sämtliche Metallschichten werden typischerweise aufgedampft.

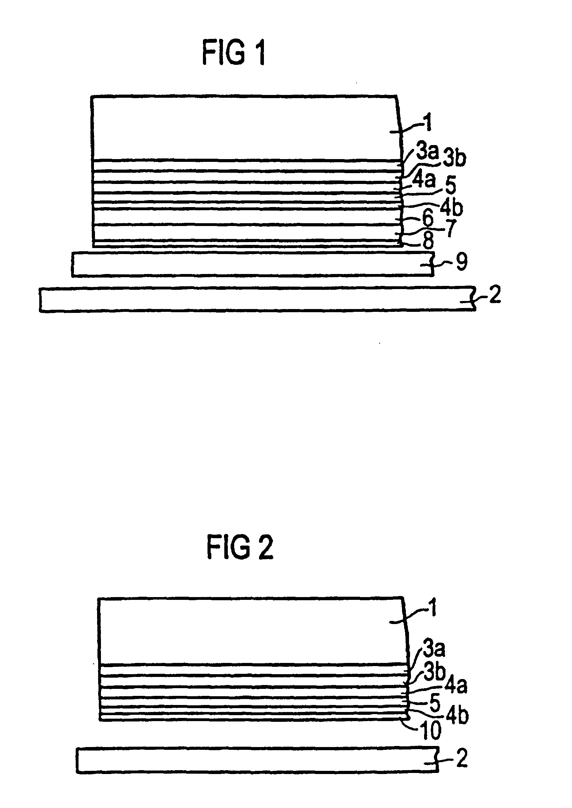

In der Figur 1 ist die Schichtfolge der Metalle vor dem Verlöten gezeigt. Die Folge von Metallschichten enthält eine Aluminiumschicht 3, die auf einem Silizium-Halbleiterkörper 1 aufgedampft ist. Die Aluminiumschicht 3 haftet gut auf dem Silizium und bildet insbesondere mit p-dotiertem Silizium einen einwandfreien ohmschen Kontakt. Die Aluminiumschicht 3 besteht aus einer ca. 30 nm dicken ersten Aluminiumschicht 3a und einer zweiten ca. 70 nm dicken Aluminiumschicht 3b. Zwischen dem Abscheiden der Aluminiumschicht 3a und dem Abscheiden der Aluminiumschicht 3b wurde der beschichtete Silizium-Halbleiterkörper 1 bei einer Temperatur von ungefähr 350°C zwischen 10 Minuten und 90 Minuten getempert. Durch dieses "in-situ-Tempern" des Silizium-Halbleiterkörpers 1 wird eine besonders gute Haftung der Aluminiumschicht 3a auf dem Silizium erreicht.

Auf der Aluminiumschicht 3 sitzt eine Titanschicht 4, die als Haftvermittler und Diffusionssperre zwischen einer auf der Titanschicht 4 sitzenden Nickelschicht 5 und der Aluminiumschicht 3 dient.

Die Titanschicht 4 besteht aus einer ersten ungefähr 30 nm dicken Titanschicht 4a und einer zweiten ebenfalls ungefähr 30 nm dicken Titanschicht 4b. Zwischen der ersten Titanschicht 4a und der zweiten Titanschicht 4b sitzt eine ungefähr 40 nm dicke Titannitridschicht 5. Die Titannitridschicht 5 kompensiert einen Großteil der durch die unterschiedlichen thermischen Ausdehnungskoeffizienten auftretenden Scheibenverbiegungen.

Auf der Titanschicht 4b ist eine Nickelschicht 6 aufgebracht, die eine Dicke von ungefähr 1000 nm aufweist. Diese Nickelschicht 6 dient im hier gezeigten Ausführungsbeispiel zur Verlötung mit der metallenen Trägerplatte 2, die vorzugsweise aus Kupfer besteht. Auf die Nickelschicht 6 ist wiederum eine Haftvermittlerschicht 7 aus Titan aufgebracht, die hier eine Dicke von ungefähr 4 nm aufweist. Die Haftvermittlerschicht 7 kann aber auch aus anderen Materialien bestehen, insbesondere aus Chrom. Auf der Haftvermittlerschicht 7 ist dann eine Oxidationsschutzschicht 8 aus einem Edelmetall aufgebracht, im gezeigten Ausführungsbeispiel besteht die Oxidationsschutzschicht 8 aus Silber. Es ist aber auch die Verwendung von Palladium, Gold oder anderen Edelmetallen denkbar. Die Haftvermittlerschicht 7 wirkt einem Ablösen der gezeigten Silberschicht von der Nickelschicht 6 entgegegen.

Beim Lötvorgang wird dann zwischen die Oxidationsschutzschicht 8 und die metallene Trägerplatte 2 das Lötmaterial 9 gebracht, so daß beim Lötvorgang zwischen Nickel und Kupfer eine metallurgische Verbindung entsteht.

In der Figur 2 ist ein anderes Metallisierungssystem dargestellt, wobei aber die Besonderheiten an der Aluminiumschicht 3 und der Titanschicht 5 den Besonderheiten in der Figur 1 entsprechen. Auf eine Diskussion der Aluminiumschicht 3 und der Titanschicht 5, insbesondere des "in-situ-Temperns" der Aluminiumschicht 3 und des Einbaus und der Wirkungsweise der Titannitridschicht 6 wird hier verzichtet und auf die Beschreibungsteile weiter oben verwiesen.

Im Gegensatz zur Metallisierung aus Figur 1 ist hier auf die Titanschicht 5b nicht eine Nickelschicht abgeschieden worden sondern direkt eine Lotmaterialschicht 10 aus Zinn aufgebracht. Die hier gezeigte Zinnschicht kann eine Dicke von 1000 bis 3000 nm aufweisen. Eine Dicke von etwa 2700 nm hat sich als besonders zweckmäßig erwiesen.

Der so metallisierte Silizium-Halbleiterkörper 1 wird dann auf die metallene Trägerplatte 2 gedruckt, die in der Regel aus Kupfer besteht, und bei ungefähr 300°C unter einer Schutzgasatmosphäre oder unter Vakuumbedingungen mit dieser verbunden, wobei eine metallurgische Verbindung zwischen der Titanschicht 5b, der Lotmaterialschicht 10 und der Trägerplatte 2 entsteht, die bis zu einer Temperatur von ca. 450°C stabil ist.

Technologisch wird durch das erfindungsgemäße Verfahren und die erfindungsgemäße Metallisierung die Möglichkeit eröffnet, die Dicken von Silizium-Halbleitersubstraten, insbesondere die Dicken von Silizium-Halbleitersubstraten die für Leistungstransistoren bzw. IGBT's in Vertikalbauweise vorgesehen sind, weiter zu verringern, was zur Verbesserung der Durchlaßeigenschaft bei diesen führt.

## Patentansprüche

1. Aus Silizium bestehender Halbleiterkörper (1), der mit einer metallenen Trägerplatte (2) verlötbar ist, und der vor dem Löten ausgehend vom Silizium in Richtung zur Trägerplatte eine Aluminiumschicht (3) und eine Diffusionssperrschicht aufweist,
wobei als Diffusionssperrschicht eine Titanschicht (4) vorgesehen ist, **dadurch gekennzeichnet, dass** in die Titanschicht (4) eine Titannitridschicht (5) eingebracht ist.'

2. Halbleiterkörper nach Anspruch 1,
**dadurch gekennzeichnet,**
**daß** auf die Titanschicht (4) eine Nickelschicht (6) aufgebracht ist.

3. Halbleiterkörper nach Anspruch 2,
**dadurch gekennzeichnet,**
**daß** auf die Nickelschicht (6) eine Oxidationschutzschicht (8) aufgebracht ist.

4. Halbleiterkörper nach Anspruch 3,
**dadurch gekennzeichnet,**
**daß** zwischen die Nickelschicht (6) und die Oxidationsschutzschicht (8) eine Haftvermittlerschicht (7) aufgebracht ist.

5. Halbleiterkörper nach Anspruch 1,
**dadurch gekennzeichnet,**
**daß** auf der Titanschicht (4) eine Lotmaterialschicht (10) aufgebracht ist.

6. Halbleiterkörper nach Anspruch 5,
**dadurch gekennzeichnet,**
**daß** als Lotmaterialschicht (10) eine Zinn- oder Blei- oder Galliumschicht vorgesehen ist.

7. Herstellverfahren für einen aus Silizium bestehenden Halbleiterkörper (1) der mit einer metallenen Trägerplatte (2) verlötbar ist, nach Anspruch 1 mit folgenden Schritten:
a) Auf den Halbleiterkörper (1) wird eine Aluminiumschicht (3) abgeschieden;
b) auf die Aluminiumschicht (3) wird eine Titanschicht (4a) abgeschieden;
c) auf die Titanschicht (4a) wird eine Titannitridschicht (5) abgeschieden;
d) auf die Titannitridschicht (5) wird eine Titanschicht (4b) abgeschieden.

8. Verfahren nach Anspruch 7,
**gekennzeichnet durch**
folgende Schritte:
e) Auf die Titanschicht (4b) wird eine Nickelschicht (6) abgeschieden;
f) auf die Nickelschicht (6) wird eine Oxidationsschutzschicht (8) abgeschieden.

9. Verfahren nach Anspruch 8,
**gekennzeichnet durch**
folgenden Schritt:
g) Zwischen den Schritten e) und f) wird eine Haftvermittlerschicht (7) auf die Nickelschicht (6) abgeschieden.

10. Verfahren nach Anspruch 7,
**gekennzeichnet durch**
folgenden Schritt:
e') Auf die Titanschicht (4b) wird eine Lotmaterialschicht (10) abgeschieden.

11. Verfahren nach einem der Ansprüche 7 bis 10, **gekennzeichnet durch**
folgende Schritte:
a₁) Auf den Halbleiterkörper (1) wird eine dünne Aluminiumschicht (3a) aufgebracht;
a₂) der so prozessierte Halbleiterkörper (1) wird getempert;
a₃) danach wird auf die Aluminiumschicht (3a) eine weitere Aluminiumschicht (3b) abgeschieden.

## Claims

1. Semiconductor body (1) which consists of silicon, can be soldered to a metallic carrier plate (2) and prior to the soldering, starting from the silicon in the direction towards the carrier plate has an aluminium layer (3) and a diffusion barrier layer, the diffusion barrier layer provided being a titanium layer (4), **characterized in that** a titanium nitride layer (5) is introduced into the titanium layer (4).

2. Semiconductor body according to Claim 1, **characterized in that** a nickel layer (6) is applied to the titanium layer (4).

3. Semiconductor body according to Claim 2, **characterized in that** an oxidation-prevention layer (8) is applied to the nickel layer (6).

4. Semiconductor body according to Claim 3, **characterized in that** a bonding layer (7) is applied between the nickel layer (6) and the oxidation-prevention layer (8).

5. Semiconductor body according to Claim 1, **characterized in that** a layer of solder material (10) is applied to the titanium layer (4).

6. Semiconductor body according to Claim 5, **characterized in that** the layer of solder material (10) provided is a layer of tin or lead or gallium.

7. Process for producing a semiconductor body (1) which consists of silicon and can be soldered to a metallic carrier plate (2), according to Claim 1, comprising the following steps:
a) an aluminium layer (3) is deposited on the semiconductor body (1);
b) a titanium layer (4a) is deposited on the aluminium layer (3);
c) a titanium nitride layer (5) is deposited on the titanium layer (4a);
d) a titanium layer (4b) is deposited on the titanium nitride layer (5).

8. Process according to Claim 7, **characterized by** the following steps:
e) a nickel layer (6) is deposited on the titanium layer (4b);
f) an oxidation-prevention layer (8) is deposited on the nickel layer (6).

9. Process according to Claim 8, **characterized by** the following step:
g) a bonding layer (7) is deposited on the nickel layer (6) between steps e) and f).

10. Process according to Claim 7, **characterized by** the following step:
e') a layer of solder material (10) is deposited on the titanium layer (4b).

11. Process according to one of Claims 7 to 10, **characterized by** the following steps:
a₁) a thin aluminium layer (3a) is applied to the semiconductor body (1);
a₂) the semiconductor body (1) processed in this way is conditioned;
a₃) then, a further aluminium layer (3b) is deposited on the aluminium layer (3a).

## Revendications

1. Semi-conducteur (1) composé de silicium, pouvant être brasé avec une plaque support (2) métallique, et qui présente, avant le brasage en partant du silicium en direction de la plaque support, une couche d'aluminium (3) et une couche d'arrêt de diffusion, une couche de titane (4) étant prévue comme couche d'arrêt de diffusion,
**caractérisé en ce qu'**
une couche de nitrure de titane (5) est appliquée dans la couche de titane (4).

2. Semi-conducteur selon la revendication 1,
**caractérisé en ce qu'**
une couche de nickel (6) est appliquée sur la couche de titane (4).

3. Semi-conducteur selon la revendication 2,
**caractérisé en ce qu'**
une couche d'antioxydant (8) est appliquée sur la couche de nickel (6).

4. Semi-conducteur selon la revendication 3,
**caractérisé en ce qu'**
une couche d'agent adhésif (7) est appliquée entre la couche de nickel (6) et la couche d'antioxydant (8).

5. Semi-conducteur selon la revendication 1,
**caractérisé en ce qu'**
une couche de matériau à braser (10) est appliquée sur la couche de titane (4).

6. Semi-conducteur selon la revendication 5,
**caractérisé en ce qu'**
une couche d'étain ou de plomb ou de gallium est prévue comme couche de matériau à braser (10).

7. Procédé de fabrication d'un semi-conducteur (1) composé de silicium pouvant être brasé avec une plaque support (2) métallique, selon la revendication 1,
**caractérisé par**
les étapes suivantes :
a) une couche d'aluminium (3) est déposée sur le semi-conducteur (1),
b) une couche de titane (4a) est déposée sur la couche d'aluminium (3),
c) une couche de nitrure de titane (5) est déposée sur la couche de titane (4a),
d) une couche de titane (4b) est déposée sur la couche de nitrure de titane (5).

8. Procédé selon la revendication 7,
**caractérisé par**
les étapes suivantes :
e) une couche de nickel (6) est déposée sur la couche de titane (4b),
f) une couche d'antioxydant (8) est déposée sur la couche de nickel (6).

9. Procédé selon la revendication 8,
**caractérisé par**
l'étape suivante :
g) une couche d'agent adhésif (7) est déposée sur la couche de nickel (6) entre les étapes e) et f).

10. Procédé selon la revendication 7,
**caractérisé par**
l'étape suivante :
e') une couche de matériau à braser (10) est déposée sur la couche de titane (4b).

11. Procédé selon l'une quelconque des revendications 7 à 10,
**caractérisé par**
les étapes suivantes :
a1) une mince couche d'aluminium (3a) est déposée sur le semi-conducteur (1),
a2) le semi-conducteur (1) ainsi traité est recuit,
a3) une autre couche d'aluminium (3b) est ensuite déposée sur la couche d'aluminium (3a).
